Europäisches Patentamt

European Patent Office

Office européen des brevets

(11) Veröffentlichungsnummer: **0 309 719 B1**

(12) **EUROPÄISCHE PATENTSCHRIFT**

(45) Veröffentlichungstag der Patentschrift: **22.07.92**

(51) Int. Cl.⁵: **G11B 7/09**, H03F 1/30

(21) Anmeldenummer: **88113479.5**

(22) Anmeldetag: **19.08.88**

(54) **Gerät zur Wiedergabe von Daten.**

(30) Priorität: **30.09.87 DE 3732997**

(43) Veröffentlichungstag der Anmeldung:
**05.04.89 Patentblatt 89/14**

(45) Bekanntmachung des Hinweises auf die
Patenterteilung:
**22.07.92 Patentblatt 92/30**

(84) Benannte Vertragsstaaten:
**AT BE CH DE ES FR GB GR IT LI LU NL SE**

(56) Entgegenhaltungen:
**EP-A- 0 190 438**
**EP-A- 0 225 258**
**WO-A-87/05171**

**PATENT ABSTRACTS OF JAPAN, Band 8, Nr.
97 (P-272)[1534], 8. Mai 1984, Seite 13; &
JP-A-59 8144**

**PATENT ABSTRACTS OF JAPAN, Band 7, Nr.
234 (P-230)[1379], 18. Oktober 1983, Seite 4; &
JP-A-58 121 139**

**PATENT ABSTRACTS OF JAPAN, Band 7, Nr.
160 (P-210)[1305], 14. Juli 1983, Seite 44; &
JP-A-58 68 247**

(73) Patentinhaber: **Deutsche Thomson-Brandt
GmbH
Hermann-Schwer-Strasse 3 Postfach 1307
W-7730 Villingen-Schwenningen(DE)**

(72) Erfinder: **Kurz, Arthur
Ludwigsburgerstrasse 26
W-7500 Karlsruhe 41(DE)**

Rank Xerox (UK) Business Services

## Beschreibung

Die Erfindung betrifft ein Gerät zur Wiedergabe von Daten, die mittels einer optischen Abtastvorrichtung aus den Datenspuren eines Aufzeichnungsträgers lesbar sind, in dem mindestens ein Lichtstrahl auf den Aufzeichnungsträger mittels eines Fokusregelkreises fokussierbar und mittels eines Spurregelkreises auf den Datenspuren führbar ist, in dem der Lichtstrahl vom Aufzeichnungsträger auf einen Photodetektor reflektiert wird, mittels dem ein elektrisches Datensignal, ein Fokusfehlersignal als Ist-Wert für den Fokusregelkreis und ein Spurfehlersignal als Ist-Wert für den Spurregelkreis erzeugt werden, in dem zur Kompensation der Off-Set-Spannung des Regelverstärkers des Fokusregelkreises die hochfrequenten Anteile des Fokusfehlersignals ausgewertet und minimiert werden werden, in dem der die Daten lesende Lichtstrahl auf vier Photodioden fokussiert wird, in dem die miteinander verbundenen Kathoden der vier Photodioden an einer Spannung liegen und in dem die miteinander verbundenen Anoden der ersten und zweiten Photodiode mit dem invertierenden Eingang eines das Fokusfehlersignal am Ausgang liefernden Differenzverstärkers verbunden sind, dessen nichtinvertierender Eingang mit den ebenfalls miteinander verbundenen Anoden der zweiten und dritten Photodiode (B, D) verbunden ist.

Derartige Geräte, z.B. CD-Spieler, magneto-optische Geräte zur Wiedergabe und Aufzeichnung, Aufzeichnungs- und Wiedergabegeräte für Draw-Discs oder Vidoeplattenspieler sind mit einer optischen Abtastvorrichtung, bestehend aus einer Laserdiode, mehreren Linsen, einem Prismenstrahlteiler und einem Photodetektor ausgestattet. Aufbau und Funktion einer optische Abtastvorrichtung, eines sogenannten optical pick-ups sind in electronic components & applications, Vol. 6, No. 4, 1984 auf Seite 209 - 215 beschrieben.

Der von der Laserdiode ausgesendete Lichtstrahl wird mittels Linsen auf die CD-Platte fokussiert und von dort auf einen Photodetektor reflektiert. Aus dem Ausgangssignal des Photodetektors werden die auf der CD-Platte gespeicherten Daten und der Ist-Wert für den Fokus- und für den Spurregelkreis gewonnen. In der genannten Literaturstelle wird der Ist-Wert für den Fokusregelkreis als focusing error bezeichnet, während für den Ist-Wert des Spurregelkreises der Ausdruck radial tracking error gewählt ist.

Als Stellglied für den Fokusregelkreis dient eine Spule, über deren Magnetfeld eine Objektivlinse entlang der optischen Achse bewegbar ist. Der Fokusregelkreis bewirkt nun durch Verschieben der Objektivlinse, daß der von der Laserdiode ausgesendete Lichtstrahl stets auf die CD-Platte fokussiert wird. Mittels des Spurregelkreises, der oft auch als Radialantrieb bezeichnet wird, ist die optische Abtastvorrichtung bezüglich der CD-Platte in radialer Richtung verschiebbar. Dadurch kann der Lichtstrahl auf den spiralförmigen Datenspuren der CD-Platte geführt werden.

Bei einigen Geräten ist der Radialantrieb aus einem sogenannten Grob- und einem sogenannten Feinantrieb aufgebaut. Der Grobantrieb ist beispielsweise als Spindel ausgeführt, mittels der die gesamte optische Abtastvorrichtung aus der Laserdiode, den Linsen, dem Prismenstrahlteiler und dem Photodetektor radial verschiebbar ist. Mit dem Feinantrieb ist der Lichtstrahl in radialer Richtung z.B. um einen vorgebbaren kleinen Winkel kippbar, so daß der Lichtstrahl allein durch diese Kippbewegung ein kleines Stück entlang eines Radius der CD-Platte fahren kann.

Um eine einwandfreie Wiedergabe der Daten, seien es nun z.B. Bild und Ton bei einem Videoplattenspieler oder bloß der Ton bei einem CD-Spieler, zu erzielen, ist neben einer genauen Fokussierung des Lichtstrahls auf die Video- bzw. CD-Platte eine präzise Führung entlang den Datenspuren der Platte erforderlich. Der Regelverstärker des Fokus- und des Spurregelkreises ist aber wie jeder andere Regelverstärker auch mit einer Off-Set-Spannung behaftet, deren Größe einerseits von der Temperatur abhängt und andererseits einer langfristigen Drift unterliegt. Die langfristige Drift der Off-Set-Spannung wie auch anderer Parameter eines Verstärkers werden durch Alterung des Verstärkers verursacht.

Damit die Datenwiedergabe nicht durch die Off-Set-Spannung des Regelverstärkers des Fokusregelkreises gestört wird, ist eine Kompensation der Off-Set-Spannung nötig. Durch manuelles Einstellen eines in Regelkreis vorgesehenen Abgleichpotentiometers läßt sich eine Kompensation jedoch nur näherungsweise durchführen, weil Änderungen der Off-Set-Spannung infolge Temperaturschwankungen und infolge Alterung des Regelverstärkers unberücksichtigt bleiben.

Aus der JP-A-59 8144 ist eine Schaltungsanordnung zur Kompensation der Offset-Spannung in einem Fokusregelkreis bekannt. Hierzu ist ein Modulator vorgesehen, der das Licht des Lasers moduliert, das auf den Aufzeichnungsträger fokussiert wird. Die vom modulierten Laserlicht verursachten Modulationsanteile im Fokusfehlersignal werden detektiert und durch eine Kompensationsspannung am Eingang des Regelverstärkers zu Null gemacht.

Es ist daher Aufgabe der Erfindung, ein Gerät zur Datenwiedergabe gemäß Oberbegriff des Anspruchs 1 so zu gestalten, daß die Off-Set-Spannung des Regelverstärkers im Fokusregelkreis automatisch während des Betriebs kompensiert wird, ohne hierfür zusätzlich einen Modulatur zum Modulieren der Laserdiode vorsehen zu müssen.

Die Erfindung löst diese Aufgabe durch die im Anspruch 1 angegebene Merkmalskombination.

Es zeigen

Figur 1 einen Photodetektor eines erfindungsgemäßen CD-Spielers

Figur 2 ein Ausführungsbeispiel der Erfindung.

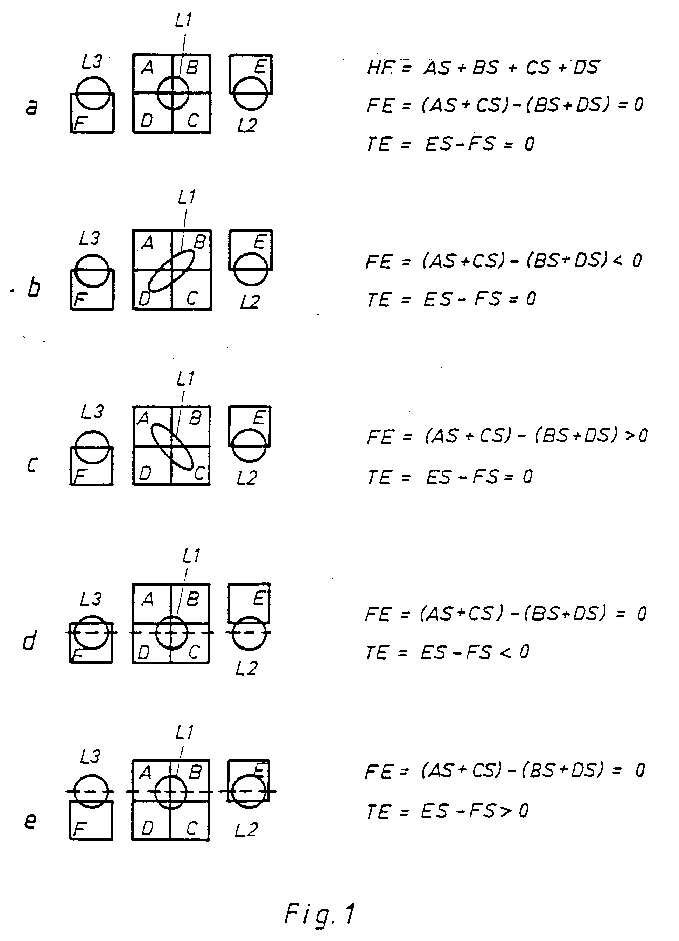

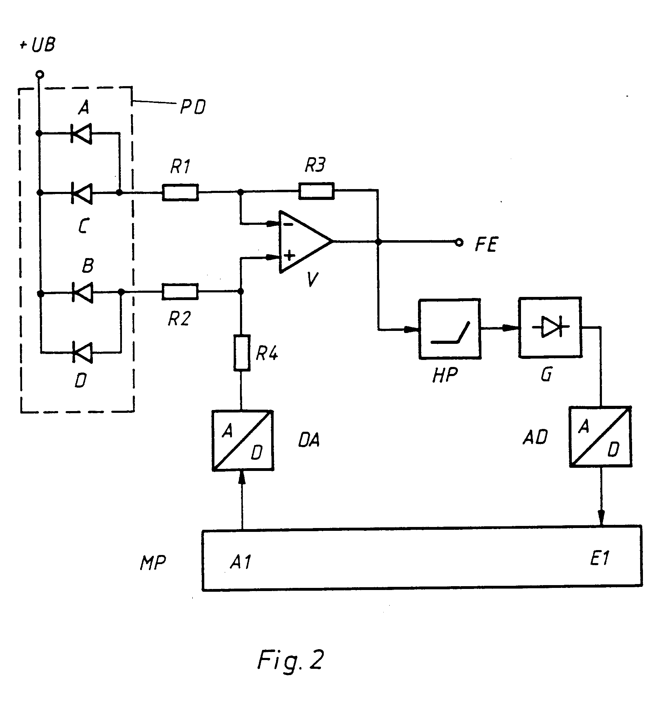

Anhand der Figuren 1 und 2 wird die Erfindung nun erläutert.

In der Figur 1 ist der Photodetektor PD der optischen Abtastvorrichtung eines CD-Spielers gezeigt, bei der drei Laserstrahlen L1, L2 und L3 auf die CD-Platte fokussiert werden. Eine derartige Abtastvorrichtung wird in der eingangs genannten Literaturstelle three-beam pick-up genannt.

Beim Photodetektor sind vier quadratförmige Photodioden A, B, C und D so zusammengefügt, daß sie wiederum ein Quadrat bilden. Bezüglich dieses aus den vier Photodioden A, B, C und D gebildeten Quadrates liegen sich zwei weitere ebenfalls quadratförmige Photodioden E und F diagonal gegenüber.

Der mittler Laserstrahl L1, der auf die vier Photodioden A, B, C und D fokussiert wird, erzeugt das Datensignal $HF = AS + BS + CS + DS$ und das Fokusfehlersignal $FE = (AS + CS) - (BS + DS)$. Die beiden äußeren Lichtstrahlen L2 und L3, von denen der vordere L2 auf die Photodiode E, der hintere L3 auf die Photodiode F fällt, erzeugen das Spurfehlersignal $TE = ES - FS$. Mit AS, BS, CS, DS, ES und FS sind jeweils die Photospannungen der Photodioden A, B, C, D, E und F bezeichnet. Weil in der optischen Abtastvorrichtung im Strahlengang des mittleren Laserstrahls L1 eine astigmatisch wirkende Kollimatorlinse vorgesehen ist, ist der mittlere Laserstrahl L1 bei genauer Fokussierung auf dem großen Quadrat, das aus den vier Photodioden A, B, C und D gebildet wird, kreisförmig, während er bei Defokussierung Ellipsenform annimmt.

Figur 1a zeigt den Fall der Fokussierung und der genauen Spurführung, auf die später noch eingegangen wird. Weil der vom Laserstrahl L1 auf dem großen Quadrat gebildete Lichtfleck Kreisform hat, ergibt sich das Fokusfehlersignal zu $FE = (AS + CS) - (BS + DS) = 0$. Am Wert 0 des Fokusfehlersignals FE erkennt der Fokusregelkreis, daß genau fokussiert ist.

In Figur 1b ist nun der eine Fall der Defokussierung, daß die CD-Platte zu weit von der Objektivlinse entfernt ist, dargestellt. Das Fokusfehlersignal FE ist negativ: $FE = (AS + CS) - (BS + DS) < 0$. Am negativen Wert des Fokusfehlersignals FE erkennt der Fokusregelkreis, daß der Abstand zwischen der CD-Platte und der Objektivlinse zu groß ist. Deshalb wird die Objektivlinse vom Stellglied des Fokusregelkreises so weit auf die CD-Platte zubewegt, bis das Fokusfehlersignal FE null wird.

Den anderen Fall der Defokussierung, daß die Objektivlinse zu nahe an der CD-Platte liegt, ist in Figur 1c gezeigt. Das Fokusfehlersignal FE hat einen positiven Wert: $FE = (AS + CS) - (BS + DS) > 0$. Am positiven Wert des Fokusfehlersignals FE erkennt der Fokusregelkreis, daß die Objektivlinse zu nahe an der CD-Platte liegt. Die Objektivlinse wird daher vom Stellglied so weit von der CD-Platte wegbewegt, bis das Fokusfehlersignal FE zu null wird.

Es wird nun erläutert, wie die Spurführung mittels des Spurregelkreises erfolgt.

In den Figuren 1a, 1b und 1c folgen die Laserstrahlen L1, L2 und L3 genau der Spur. Das Spurfehlersignal TE hat den Wert Null. $TE = ES - FS = 0$.

In der Figur 1d ist der Fall dargestellt, daß die Laserstrahlen L1, L2 und L3 nach rechts von der Spur verschoben sind. Das Spurfehlersignal nimmt einen negativen Wert an: $TE = ES - FS < 0$. Das Stellglied des Spurregelkreises bewegt die optische Abtastvorrichtung nun so weit nach links, bis das Spurfehlersignal TE null wird.

Im entgegengesetzten Fall, wenn die Laserstrahlen nach links von der Spur verschoben sind, ist das Spurfehlersignal positiv: $TE = ES - FS > 0$. Nun bewegt das Stellglied des Spurregelkreises die optische Abtastvorrichtung so weit nach rechts bis das Spurfehlersignals TE null wird.

Anhand der Figur 2 wird zuerst der Aufbau eines ersten Ausführungsbeispieles beschrieben und anschließend seine Funktion erläutert.

In der Figur 2 liegen die miteinander verbundenen Kathoden der vier Photodioden A, B, C und D des Photodetektors PD an einer Spannung +UB. Die miteinander verbundenen Anoden der Photodioden A und C sind über einen Widerstand R1 mit dem invertierenden Eingang eines Differenzverstärkers V verbunden, dessen nichtinvertierender Eingang über einen Widerstand R2 mit den ebenfalls miteinander verbundenen Anoden der Dioden B und D verbunden ist. Der Ausgang des Differenzverstärkers V, an dem das Fokusfehlersignal FE für das Stellglied des Fokusregelkreises abgreifbar ist, ist mit dem Eingang eines Hochpasses HP verbunden und über einen Widerstand R3 auf seinen invertierenden Eingang rückgekoppelt. Der Ausgang des Hochpasses HP ist mit dem Eingang eines Gleichrichters G verbunden, der als Spitzenwert-, Mittelwert- oder Effektivwertbildner ausgeführt sein kann. Der Ausgang des Gleichrichters G ist mit dem Eingang eines Analog-Digital-Wandlers AD verbunden, dessen Ausgang mit dem Eingang E1 einer Steuerschaltung MP verbunden ist. Der Ausgang A1 der Steuerschaltung MP ist mit dem Eingang eines Digital-Analog-Wandlers DA verbunden, dessen Ausgang über einen Widerstand R4 mit dem nichtinvertierenden Eingang des Differenzverstärkers V verbunden ist.

Die hochfrequenten Anteile des Fokusfehlersignals FE werden mittels des Hochpasses HP herausgesiebt und an den Eingang des Gleichrichters G weitergeleitet. Der Gleichrichter G bildet den Spitzen-, den Mittel-oder den Effektivwert der hochfrequenten Anteile des Fokusfehlersignals FE. Mittels des Analog-Digital-Wandlers AD wird z.B. der analoge Spitzenwert in einen digitalen Wert umgewandelt und dem Eingang der Steuerschaltung MP zugeführt. Die Steuerschaltung MP ändert nun so lange den digitalen Wert an ihrem Ausgang A1, der über den Digital-Analog-Wandler DA und den Widerstand R4 als Off-Set-Kompensationsspannung dem nichtinvertierenden Eingang des Differenzverstärkers V zugeführt wird, bis der digitale Wert am Ausgang des Analog-Digital-Wandlers AD ein Minimum annimmt, denn dann ist der Pegel der hochfrequenten Anteile des Fokusfehlersignals FE minimal. Die Off-Set-Spannung des Differenzverstärkers V ist in diesem Fall optimal kompensiert. Die Steuerschaltung MP kann beispielsweise als Mikroprozessor ausgeführt sein.

Weil bei der Erfindung, während der CD-Spieler in Betrieb ist, ständig die Off-Set-Spannung des Regelverstärkers V des Fokusregelkreises kompensiert wird, spielen Alterung der Bauteile und Temperaturänderungen keine Rolle mehr. Die Off-Set-Kompensationsspannung wird sowohl bei langsamen Abweichungen der Off-Set-Spannung infolge Alterung, sogenannter Drift, als auch bei schnellen Abweichungen durch rasche Temperaturschwankungen sofort korrigiert. Bei der Produktion des erfindungsgemäßen CD-Spielers entfällt beim Fokusregelkreis ein Abgleich von Hand.

Die Erfindung ist nicht nur auf CD-Spieler beschränkt. Sie läßt sich in vorteilhafter Weise z.B. bei Draw-Disc-Spielern, Vidoeplattenspielern und magneto-optischen Geräten verwirklichen.

**Patentansprüche**

1. Gerät zur Wiedergabe von Daten, die mittels einer optischen Abtastvorrichtung aus den Datenspuren eines Aufzeichnungsträgers lesbar sind, in dem mindestens ein Lichtstrahl auf den Aufzeichnungsträger mittels eines Fokusregelkreises fokussierbar und mittels eines Spurregelkreises auf den Datenspuren führbar ist, in dem der Lichtstrahl vom Aufzeichnungsträger auf einen Photodetektor (PD) reflektiert wird, mittels dem ein elektrisches Datensignal (HF), ein Fokusfehlersignal (FE) als Ist-Wert für den Fokusregelkreis und ein Spurfehlersignal (TE) als Ist-Wert für den Spurregelkreis erzeugt werden, in dem zur Kompensation der Off-Set-Spannung des Regelverstärkers des Fokusregelkreises die hochfrequenten Anteile des Fokusfehlersignals (FE) ausgewertet und minimiert werden werden, in dem der die Daten lesende Lichtstrahl (L2) auf vier Photodioden (A, B, C, D) fokussiert wird, in dem die miteinander verbundenen Kathoden der vier Photodioden (A, B, C, D) an einer Spannung ( + UB) liegen, in dem die miteinander verbundenen Anoden der ersten und zweiten Photodiode (A, C) mit dem invertierenden Eingang eines das Fokusfehlersignal am Ausgang liefernden Differenzverstärkers (V) verbunden sind, dessen nichtinvertierender Eingang mit den ebenfalls miteinander verbundenen Anoden der zweiten und dritten Photodiode (B, D) verbunden ist, **dadurch gekennzeichnet,** daß der Ausgang des Differenzverstärkers (V), an dem das Fokusfehlersignal (FE) abgreifbar ist, mit dem Eingang eines Hochpasses (HP) verbunden ist, daß der Ausgang des Hochpasses (HP) mit dem Eingang eines Gleichrichters (G) verbunden ist, dessen Ausgang mit dem Eingang eines Analog-Digital-Wandlers (AD) verbunden ist, daß der Ausgang des Analog-Digital-Wandlers (AD) mit dem Eingang (E1) einer Steuerschaltung (MP) verbunden ist, deren Ausgang (A1) mit dem Eingang eines Digital-Analog-Wandlers (DA) verbunden ist, daß der Ausgang des Digital-Analog-Wandlers (DA) mit dem nichtinvertierenden Eingang des Differenzverstärkers (V) verbunden ist und daß die Steuereinheit (MP) den digitalen Wert an ihrem Ausgang (A1) so lange ändert, bis der digitale Wert an ihrem Eingang (E1) ein Minimum annimmt.

2. Gerät nach Anspruch 1, **dadurch gekennzeichnet,** daß zwischen den miteinander verbundenen Anoden der ersten und zweiten Diode (A, C) und dem invertierenden Eingang des Differenzverstärkers (V) ein erster Widerstand (R1) liegt, daß zwischen den miteinander verbundenen Anoden der dritten und vierten Diode (B, D) ein zweiter Widerstand (R2) liegt, daß der Ausgang des Differenzverstärkers (V) über einen dritten Widerstand (R3) auf seinen invertierenden Eingang rückgekoppelt ist und daß zwischen dem Ausgang des Digital-Analog-Wandlers (DA) und dem nichtinvertierenden Eingang des Verstärkers (V) ein vierter Widerstand (R4) liegt.

3. Gerät nach Anspruch 1 oder 2, **dadurch gekennzeichnet,** daß der Gleichrichter (G) als Spitzenwertgleichrichter wirkt.

4. Gerät nach Anspruch 1 oder 2, **dadurch gekennzeichnet,** daß der Gleichrichter (G) als Mittelwertbildner wirkt.

**5.** Gerät nach Anspruch 1 oder 2, **dadurch gekennzeichnet,** daß der Gleichrichter (G) als Effektivwertbildner wirkt.

**Claims**

**1.** Device for the reproduction of data readable by means of an optical scanning device from the data tracks of a record medium, at least one light beam being focusable onto the record medium by means of a focus control loop and guidable on the data tracks by means of a tracking control loop, the light beam being reflected by the record medium onto a photodetector (PD), by means of which an electrical data signal (HF), a focus error signal (FE) as an actual value for the focus control loop and a tracking error signal (TE) as an actual value for the tracking control loop are produced, the high-frequency portions of the focus error signal (FE) being analyzed and minimized to correct the offset voltage of the control amplifier of the focus control loop, the light beam (L1) reading the data being focused onto four photodiodes (A, B, C, D), the cathodes, which are connected to one another, of the four photodiodes (A, B, C, D) being at a voltage (+UB), the anodes, which are connected to one another, of the first and second photodiodes (A, C) being connected to the inverting input of a differential amplifier (V), which supplies the focus error signal at its output and the non-inverting input of which is connected to the anodes, which are likewise connected to one another, of the second and third photodiodes (B, D), characterized in that the output of the differential amplifier (V), at which the focus error signal (FE) is detectable, is connected to the input of a high pass (HP), that the output of the high pass (HP) is connected to the input of a rectifier (G), the output of which is connected to the input of an analog-to-digital converter (AD), that the output of the analog-to-digital converter (AD) is connected to the input (E1) of a control circuit (MP), the output (A1) of which is connected to the input of a digital-to-analog converter (DA), that the output of the digital-to-analog converter (DA) is connected to the non-inverting input of the differential amplifier (V) and that the control unit (MP) changes the digital value at its output (A1) until the digital value at its input (E1) assumes a minimum.

**2.** Device according to claim 1, characterized in that between the anodes, which are connected to one another, of the first and second diodes (A, C) and the inverting input of the differential amplifier (V) is a first resistor (R1), that between the anodes, which are connected to one another, of the third and fourth diodes (B, D) is a second resistor (R2), that the output of the differential amplifier (V) is linked back to its inverting input via a third resistor (R3) and that between the output of the digital-to-analog converter (DA) and the non-inverting input of the amplifier (V) is a fourth resistor (R4).

**3.** Device according to claim 1 or 2, characterized in that the rectifier (G) acts as a peak detector.

**4.** Device according to claim 1 or 2, characterized in that the rectifier (G) acts as a mean value former.

**5.** Device according to claim 1 or 2, characterized in that the rectifier (G) acts as an r.m.s. value former.

**Revendications**

**1.** Appareil pour la reproduction de données qui peuvent être lues au moyen d'un dispositif de balayage optique à partir des pistes de données d'un support d'enregistrement dans lequel au moins un faisceau lumineux peut être focalisé sur le support d'enregistrement au moyen d'un circuit de réglage de foyer et peut être guidé au moyen d'un circuit de réglage de piste sur les pistes de données, dans lequel le faisceau lumineux est réfléchi par le support d'enregistrement sur un détecteur photoélectrique (PD) au moyen duquel sont générés un signal de données électrique (HF), un signal d'erreur de foyer (FE) comme valeur effective pour le circuit de réglage de foyer et un signal d'erreur de piste (TE) comme valeur effective pour le circuit de réglage de piste, dans lequel les fractions de haute fréquence du signal d'erreur de foyer (FE) sont exploitées et minimisées pour la compensation de la tension offset de l'amplificateur de réglage du circuit de réglage de foyer, dans lequel le faisceau lumineux (L1) qui lit les données est focalisé sur quatre diodes photoélectriques (A, B, C, D), dans lequel les cathodes reliées l'une à l'autre des quatre diodes photoélectriques (A, B. C, D) sont appliquées à une tension (+UB) et dans lequel les anodes reliées l'une à l'autre de la première et de la seconde diode photoélectrique (A, C) sont reliées à l'entrée inverseuse d'un amplificateur différenciateur (V), qui donne le signal d'erreur de foyer à la sortie, dont l'entrée directe est reliée aux anodes également reliées l'une à l'autre de la seconde et de la troisième diode photoélectrique (B, D), **caractérisé en ce** que la sortie de l'amplificateur différenciateur (V), sur laquelle le signal d'erreur de foyer (FE) peut être prélevé, est reliée à l'entrée d'un passe-haut (HP), que la sortie du passe-haut (HP) est reliée à l'entrée d'un redresseur (G) dont la sortie est reliée à l'entrée d'un convertisseur analogique-numérique (AD), que la sortie du convertisseur analogique-numérique (AD) est reliée à l'entrée (E1) d'un circuit de commande (MP) dont la sortie (A1) est reliée à l'entrée d'un convertisseur numérique-analogique (DA), que la sortie du convertisseur numérique-analogique (DA) est reliée à l'entrée directe de l'amplificateur différenciateur (V) et que l'unité de commande (MP) modifie la valeur numérique à sa sortie (A1) jusqu'à ce que la valeur numérique ait pris un minimum à son entrée (E1).

2. Appareil selon la revendication 1, **caractérisé en ce** qu'une première résistance (R1) se trouve entre les anodes reliées l'une à l'autre de la première et de la seconde diode (A, C) et l'entrée d'inversion de l'amplificateur différenciateur (v), qu'une seconde résistance (R2) se trouve entre les anodes reliées l'une à l'autre de la troisième et de la quatrième diode (B. D), que la sortie de l'amplificateur différenciateur (V) est réappliquée par une troisième résistance (R3) à son entrée d'inversion et qu'une quatrième résistance (R4) se trouve entre la sortie du convertisseur numérique-analogique (DA) et l'entrée directe de l'amplificateur (v).

3. Appareil selon la revendication 1 ou 2, **caractérisé en ce** que le redresseur (G) agit comme un redresseur de valeur maximale.

4. Appareil selon la revendication 1 ou 2, **caractérisé en ce** que le redresseur (G) agit comme un formateur de valeur moyenne.

5. Appareil selon la revendication 1 ou 2, **caractérisé en ce** que le redresseur (G) agit comme un formateur de valeur effective.

$$HF = AS + BS + CS + DS$$
$$FE = (AS + CS) - (BS + DS) = 0$$
$$TE = ES - FS = 0$$

$$FE = (AS + CS) - (BS + DS) < 0$$
$$TE = ES - FS = 0$$

$$FE = (AS + CS) - (BS + DS) > 0$$
$$TE = ES - FS = 0$$

$$FE = (AS + CS) - (BS + DS) = 0$$
$$TE = ES - FS < 0$$

$$FE = (AS + CS) - (BS + DS) = 0$$
$$TE = ES - FS > 0$$

Fig. 1

Fig. 2